(19) **Europäisches Patentamt**

**European Patent Office**

**Office européen des brevets**

(11) **EP 1 378 755 B1**

(12) **EUROPÄISCHE PATENTSCHRIFT**

| | |
|---|---|
| (45) Veröffentlichungstag und Bekanntmachung des Hinweises auf die Patenterteilung:<br>**07.09.2005 Patentblatt 2005/36** | (51) Int Cl.⁷: **G01R 17/06**, G01K 7/20 |

(21) Anmeldenummer: **02102005.2**

(22) Anmeldetag: **05.07.2002**

(54) **Messschaltung mit einer Messbrücke und Messvorrichtung**

Electronic measuring circuit comprising a measuring bridge and measuring device

Circuit électronique de mesure comportant un pont de mesure et dispositif de mesure

(84) Benannte Vertragsstaaten:
**AT BE BG CH CY CZ DE DK EE ES FI FR GB GR IE IT LI LU MC NL PT SE SK TR**

(43) Veröffentlichungstag der Anmeldung:
**07.01.2004 Patentblatt 2004/02**

(73) Patentinhaber: **Mettler-Toledo GmbH**
**8606 Greifensee (CH)**

(72) Erfinder: **Reichmuth, Arthur**
**8620, Wetzikon (CH)**

(56) Entgegenhaltungen:
**US-A- 4 042 885      US-A- 4 063 447**
**US-A- 4 456 390**

• **PUNCOCH R JOSEF: "Operacn zesilovace v elektronice" 2002 , TECHNICKA LITERATURA BEN , PRAHA XP002226463 erste Auflage 1996 \* Abbildungen 184,A,B,267 \***

**Beschreibung**

Die Erfindung betrifft eine Messschaltung nach dem Oberbegriff des Patentanspruchs 1 und eine Messvorrichtung nach Anspruch 12. Die Erfindung betrifft insbesondere eine Messschaltung für eine Waage, in der temperaturabhängige Messabweichungen kompensiert werden.

Es ist bekannt, dass Temperaturschwankungen das Ausgangssignal eines Messgerätes, beispielsweise einer Kraftmessvorrichtung, wie sie in [1], EP 0 990 880 A2 beschrieben ist, störend beeinflussen können. In vielen Messgeräten sind daher Vorrichtungen vorgesehen, mittels derer die Temperatur eines Geräts auf einen konstanten, normalerweise über der Umgebungstemperatur liegenden Wert geregelt wird.

Eine andere Möglichkeit, den störenden Einfluss der Temperaturschwankungen auszuschalten zeigt [4], US 4 063 447 A. Sie beschreibt eine Messwiderstände enthaltende Brücke, deren verstärkte Brückenspannung den Messwert liefert. Mindestens ein Brückenzweig enthält eine steuerbare Stromquelle. Messpausen werden dazu benützt, die Stromquelle derart nachzusteuern, dass die Brückenspannung zu null gemacht wird, so dass weitere Messungen mit einer abgeglichenen Brücke gestartet werden können.

Wie ein Brückenverstärker beschaltet sein kann und dessen Ausgangsspannung sich in Abhängigkeit von veränderlichen Leitwerten in den Brückenzweigen ändert, kann beispielsweise [5], dem Lehrbuch "Operač ni zesilovač e v elektronice", 2002, Technická Literatura BEN, Praha, Seiten 267 bis 268 entnommen werden, von dem ausgehend der Oberbegriff des Anspruchs 1 abgeleitet ist.

Als weitere Möglichkeit kann eine Temperaturmessschaltung vorgesehen sein, welche ein von der gemessenen Temperatur abhängiges Signal abgibt, das einer Korrekturschaltung zuführbar ist, die zur Kompensation von Messabweichungen geeignet ist, welche durch Temperaturverschiebungen verursacht werden.

Eine derartige Temperaturmessschaltung ist beispielsweise aus [2], EP 0 173 833 A2 bekannt. Darin ist ein als Temperaturfühler dienender Messwiderstand vorgesehen, der einerseits Bestandteil eines nach dem Ladungsausgleichsprinzip arbeitenden A/D-Wandlers und andererseits Bestandteil eines Widerstandsnetzwerks ist. Dadurch entsteht ein geschlossenes System, das unter weitgehender Ausschaltung möglicher Fehlerquellen die präzise Messung des Wertes des Messwiderstands bzw. einer dazu korrespondierenden Temperatur erlaubt. Die Anwendung des Ladungsausgleichsprinzips, das auch als Charge Balancing Verfahren bekannt ist, führt dabei zu einer reinen Verhältnismessung, in der nur die Werte der Präzisionswiderstände des Widerstandsnetzwerks sowie Zeitabschnitte berücksichtigt werden, die aus der Anwendung des Ladungsausgleichsprinzips resultieren.

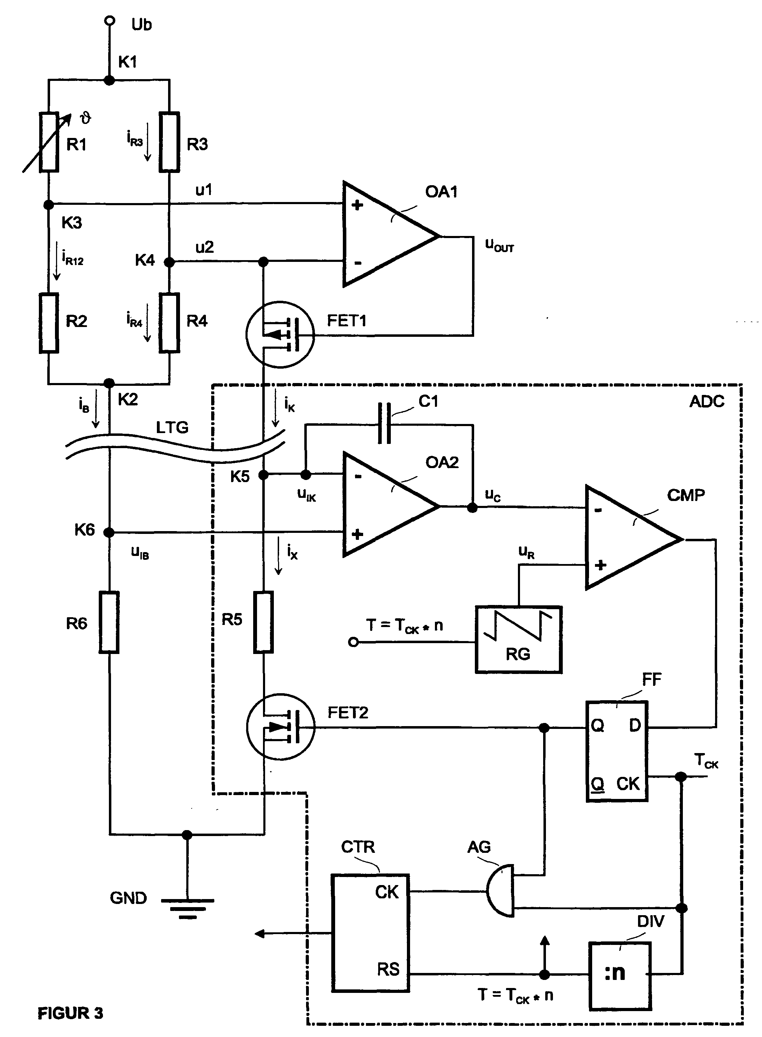

Nachteilig bei der in [2] vorgeschlagenen Messschaltung ist, dass diese aufgrund des vorgesehenen Widerstandsnetzwerks mit darin integrierten aktiven Bauteilen (siehe [2], Figur 3, Transistor T1 und Schalter S1) in weiteren Messsystemen nur beschränkt verwendbar ist. In Druckmesssystemen mit vier zu einer Messbrücke zusammengeschalteten Dehnmessstreifen, wie sie in [3], U. Tietze, Ch. Schenk, Halbleiterschaltungstechnik, 11. Auflage, 1. Nachdruck, Springer Verlag, Berlin 1999, Kapitel 23.2, Seiten 1241 und 1243 beschrieben sind, sind vorzugsweise nur die Dehnmessstreifen auf einem Messorgan, beispielsweise einer Membran, angeordnet. Sofern in der Messbrücke weitere Bauteile integriert sind, müssten diese ebenfalls auf der Membran angeordnet oder mittels Leitungen angeschlossen werden, wodurch ein entsprechender Aufwand und gegebenenfalls Einwirkungen auf den Messvorgang entstehen würden. Zudem bestehen bei der Messschaltung von [2] Einschränkungen hinsichtlich der Wahl des Messbereichs.

Ferner wäre es oft von Vorteil, wenn das Messsignal dezentral verarbeitet, beispielsweise digitalisiert werden könnte, was bei der geschlossenen Bauweise der Messschaltung von [2], bei der beide Eingänge des Integrators des A/D-Wandlers direkt mit den beiden Zweigen der Messbrücke verbunden sind, nicht zweckmässig ist.

Sofern das Messsignal in digitaler Form verfügbar sein soll, ist bei Messschaltungen ferner zu beachten, dass das Referenzsignal des A/D Wandlers konstant gehalten wird, was mit entsprechendem Aufwand verbunden ist. Ferner ist die an die Messbrücke angelegte Betriebsspannung konstant zu halten.

Die US 4 456 390 A, [6], zeigt ein weiteres Beispiel für die Berücksichtigung der sich ändernden Temperatur am oder im Messgerät. Das Temperaturmessgerät verwendet eine Thermosäule zur Erzeugung eines von der Infraroteinstrahlung abhängigen Messsignals. Ein Bezugssignal für die Referenztemperatur wird von einem Thermoelement in unmittelbarer Nachbarschaft der kalten Seite der Thermosäule geliefert. Dieses Signal wird auch dazu verwendet, die Verstärkung für das Messsignal zu beeinflussen, so dass temperaturbedingte Empfindlichkeitsänderungen der Thermosäule ausgeglichen werden. Die Vorrichtung benötigt eine ziemlich aufwändige Kompensationsschaltung.

Der vorliegenden Erfindung liegt daher die Aufgabe zugrunde, eine verbesserte, mit einer Messbrücke versehene Messschaltung zu schaffen, die vielseitiger verwendbar und kostengünstiger realisierbar ist.

Diese Aufgabe wird mit einer Messschaltung gelöst, welche die in Anspruch 1 angegebenen Merkmale aufweist. Vorteilhafte Ausgestaltungen der Erfindung sind in weiteren Ansprüchen angegeben.

Insbesondere soll eine zuverlässig arbeitende Messschaltung geschaffen werden, die zur Messung verschiedener nichtelektrischer Grössen verwendbar ist, die mittels Messfühlern messbar sind, deren jeweiliger Widerstand sich in Abhängigkeit der gemessenen Grösse ändert (siehe [3], Seiten 1222-1223, Tabelle 23.1).

Die erfindungsgemässe Messschaltung soll ferner in einfacher Weise erlauben, den Bereich frei zu wählen, innerhalb dessen die Messgrösse zu messen ist.

Weiterhin soll die erfindungsgemässe Messschaltung derart aufgebaut sein, dass die Messbrücke und der gegebenenfalls vorgesehene D/A Wandler voneinander entfernt angeordnet werden können, ohne dass Messfehler auftreten.

Die erfindungsgemässe Messschaltung soll in einer vorzugsweisen Ausgestaltung ferner, unabhängig von der Stabilität der Betriebsspannung, präzise Messresultate liefern.

Die im Anspruch 1 definierte, erfindungsgemässe Messschaltung weist eine Brückenschaltung auf, mit einem ersten und einem zweiten, über einen ersten Knotenpunkt an eine Betriebsspannung und über einen zweiten Knotenpunkt an Erde angeschlossenen Brückenzweig. Die Verbindung der Knotenpunkte mit den genannten Potenzialen kann direkt oder über Anschlusswiderstände erfolgen. Erde ist dabei nicht einschränkend als Potenzial der umgebenden Masse zu verstehen. Erde wird hier und in der Folge als Bezugspotenzial für die Betriebs- und andere elektrische Spannungen verwendet. Genau so gut könnte von Plus- und Minus-Polen gesprochen werden. Die zwei parallelgeschalteten Brückenzweige sind mit je zwei zu einem dritten und vierten Knotenpunkt zusammengeschalteten Widerständen versehen, von denen wenigstens einer seinen Wert in Abhängigkeit der zu messenden Grösse ändert. Die vier genannten Widerstände können selbstverständlich ihrerseits aus mehreren Elementen bestehen. Die beiden Brückenzweige sind grundsätzlich gleichwertig. Einer der beiden Knotenpunkte, in der Folge als vierter bezeichnet, zeichnet sich erfindungsgemäss dadurch aus, dass ihm ein zur Messgrösse proportionaler Kompensationsstrom zuführbar oder - je nach Definition - entnehmbar ist, der derart regelbar ist, dass die Differenz der am dritten und vierten Knotenpunkt auftretenden Spannungen stets Null wird.

Änderungen der Spannungen innerhalb der Brückenschaltung, die durch den Einfluss der Messgrösse auf einen oder mehrere der Brückenwiderstände entstehen, werden daher mittels des Kompensationsstroms ausgeglichen, der dem vierten, innerhalb eines Brückenzweigs vorgesehenen Knotenpunkt zugeführt wird und der gleichzeitig zur Bestimmung der Messgrösse, beispielsweise einer Temperatur $\vartheta$ oder eines Drucks p oder einer relativen Feuchtigkeit h, dient. Nachteile, die bei der Kompensation von Spannungsänderungen mittels eines in der Brückenschaltung integrierten regelbaren Widerstandes entstehen (siehe [2], Figur 3), werden somit vermieden.

Die Zuführung oder Entnahme eines entsprechenden Kompensationsstroms zur Regelung der Differenz der am dritten und vierten Knotenpunkt auftretenden Spannungen, erlaubt einen einfachen Aufbau der Messbrücke mit lediglich vier Widerständen, von denen wenigstens einer als Messwiderstand dient. Erfindungsgemäss können daher einfachste Messschaltungen mit Messbrücken realisiert werden, die beispielsweise vier Sensoren aufweisen und die lediglich mittels vier Anschlussleitungen mit weiteren Elementen der Messschaltung verbunden sind.

Ferner erlaubt die Verwendung des Kompensationsstroms anstelle von Spannungen zur Bestimmung der Messgrösse die Durchführung des Messvorgangs unter weitgehender Vermeidung von Störeinflüssen. Insbesondere kann der Kompensationsstrom über eine längere Distanz von der Brückenschaltung zu einer Auswerteschaltung, beispielsweise einem nach dem Ladungsausgleichsprinzip arbeitenden A/D Wandler übertragen werden, ohne dass der Widerstand der Übertragungsleitung oder der Übergangswiderstand von Verbindungselementen eine Rolle spielt.

In einer vorzugsweisen Ausgestaltung der Erfindung wird das Verhältnis des Kompensationsstroms und des durch den zweiten Knotenpunkt gegen Erde fliessenden Brückenstroms gemessen und zur Bestimmung der Messgrösse verwendet. Während der Kompensationsstrom von der an den ersten Knotenpunkt der Messbrücke angelegten Betriebsspannung abhängig ist, trifft dies für das Verhältnis des Kompensationsstroms zum Brückenstrom nämlich nicht mehr zu, so dass Instabilitäten der an die Brückenschaltung angelegten Betriebsspannung kompensiert werden.

Vorteilhaft ist ferner, dass der Messbereich der Messschaltung frei wählbar ist. Der Messbereich wird dabei durch entsprechende Dimensionierung der Bauteile der Messschaltung so festgelegt, dass der minimal und der maximal auftretende Wert des Kompensationsstroms die Eckwerte des Messbereichs darstellen.

Die erfindungsgemässe Messschaltung erlaubt daher unter Vermeidung von Störeinflüssen eine präzise Messung von Messgrössen, und ist daher in Messgeräten, beispielsweise in der eingangs beschriebenen Kraftmessvorrichtung, zur Korrektur von temperaturabhängigen Messabweichungen vorteilhaft einsetzbar.

Nachfolgend wird die Erfindung anhand von Zeichnungen näher erläutert. Dabei zeigen:

Figur 1    die erfindungsgemässe Messschaltung in einer einfachen Ausgestaltung mit analoger Anzeige des Kompensationsstroms bzw. der dazu proportionalen Messgrösse;

Figur 2    die erfindungsgemässe Messschaltung in einer Ausgestaltung mit einem A/D Wandler mit konstanter Referenzspannung und digitaler Anzeige des Kompensationsstroms bzw. der dazu proportionalen Messgrösse, und

Figur 3    die erfindungsgemässe Messschaltung von Figur 2, bei der dem A/D Wandler eine von der Betriebsspannung abhängige Referenzspannung zugeführt wird.

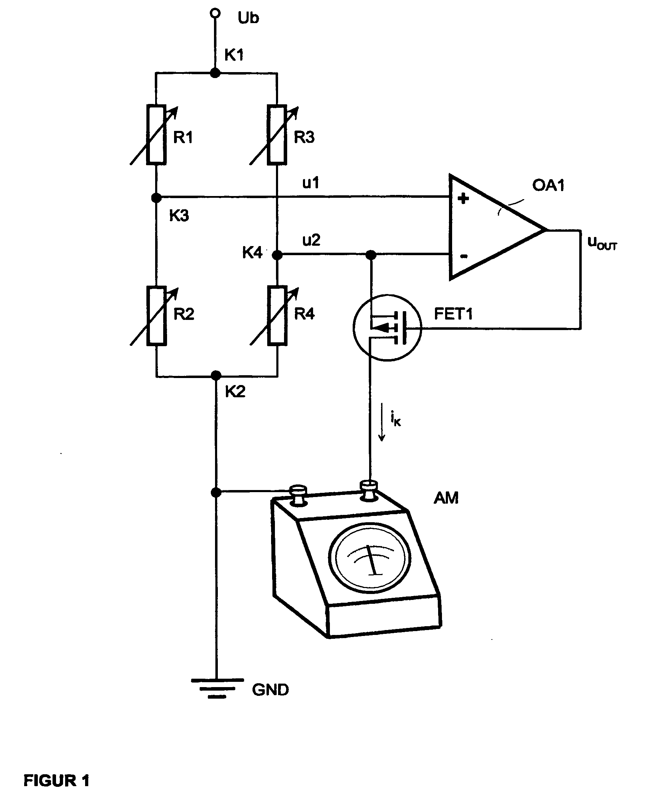

Die in Figur 1 gezeigte Messschaltung weist eine Brückenschaltung auf, bestehend aus einem ersten und einem zweiten, über einen ersten Knotenpunkt K1 an eine Betriebsspannung Ub und über einen zweiten Knotenpunkt K2 an Erde GND angeschlossenen Brückenzweig. Jeder Brückenzweig weist zwei zu einem dritten bzw. vierten Knotenpunkt K3, K4 zusammengeschaltete Widerstände R1, R2 bzw. R3, R4 auf, von denen wenigstens einer seinen Wert in Abhängigkeit einer zu messenden Grösse ändert, wie sie in [3], Seiten 1222-1223, Tabelle 23.1 aufgelistet sind.

Der Knotenpunkt K3 der in Serie geschalteten Widerstände R1, R2 des ersten Brückenzweigs ist mit dem nicht-invertierenden Eingang eines Operationsverstärkers OA1 verbunden, dessen invertierender Eingang mit dem Knotenpunkt K4 der in Serie geschalteten Widerstände R3, R4 des zweiten Brückenzweigs verbunden ist. Der Ausgang des Operationsverstärkers OA1 ist mit dem Steuereingang eines als regelbarer Widerstand dienenden P-Kanal Feldeffekttransistors FET1 verbunden, welcher den Knotenpunkt K4 des zweiten Brückenzweigs über ein Strommessgerät AM mit Erde GND verbindet. Die Differenz der an den Knotenpunkten K3, K4 bzw. an den Eingängen des Operationsverstärkers OA1 anliegenden Spannungen u1, u2 wird durch diesen, mittels Steuerung des P-Kanal Feldeffekttransistors FET1, stets auf Null geregelt. Auf einer entsprechenden Skala des Strommessgeräts AM kann daher der durch den Feldeffekttransistor fliessende Kompensationsstrom $i_K$ die gemessene Grösse analog darstellen.

Es ist ersichtlich, dass Instabilitäten der an die Messbrücke angelegten Betriebsspannung Ub bei der Messschaltung von Figur 1 zu Änderungen des Kompensationsstroms $i_K$ und somit auch der auf dem Strommessgerät AM angezeigten Werte führen, auch wenn die Messgrösse, beispielsweise die Temperatur $\vartheta$, und damit die Widerstände R1 bis R4 stabil sind.

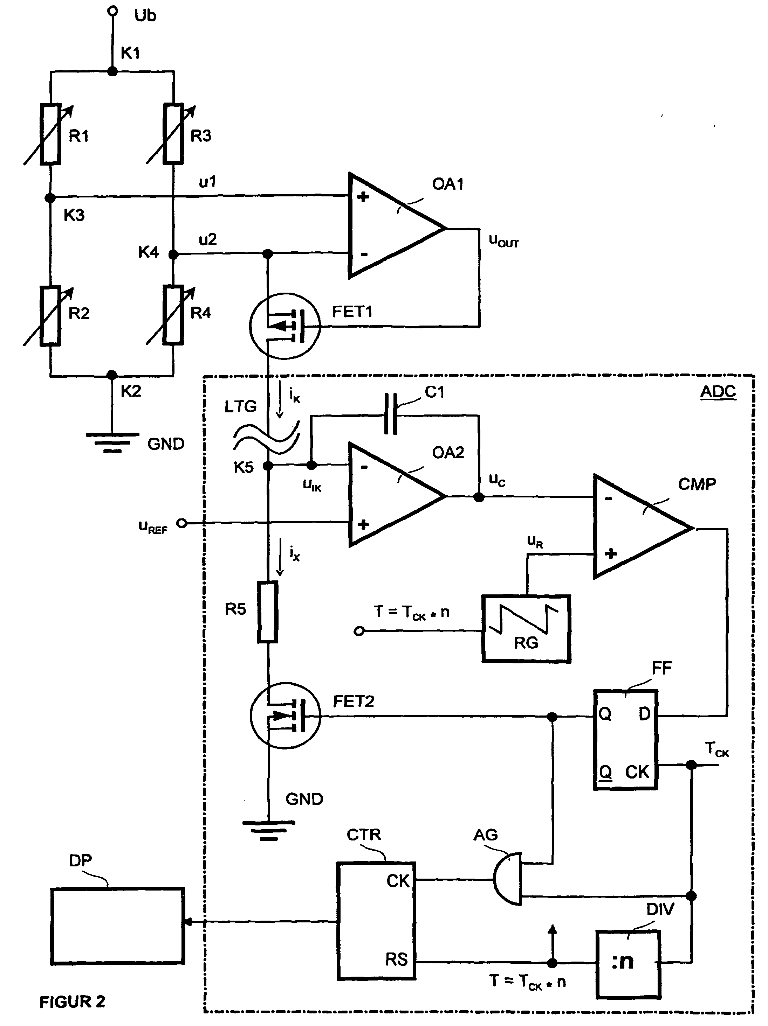

In der in Figur 2 gezeigten weiteren Ausgestaltung der Messschaltung wird der Kompensationsstrom $i_K$ nicht mittels eines Strommessgeräts analog dargestellt, sondern mittels eines A/D Wandlers gewandelt und anschliessend auf einer Anzeigeeinheit DP digital dargestellt. Die in Figur 2 gezeigte vorzugsweise Ausgestaltung des A/D Wandlers wird in einem der folgenden Abschnitte beschrieben (siehe auch [3], Kapitel 18.7, Seiten 1043 - 1047).

Dem in Figur 2 gezeigten A/D Wandler ADC wird eine konstante Spannung $u_{REF}$ zugeführt, die als Referenz für die Messung des Kompensationsstroms $i_K$ dient. Instabilitäten der Betriebsspannung Ub, welche Änderungen des Kompensationsstroms $i_K$ verursachen, beeinflussen daher auch bei dieser Messschaltung die Messergebnisse. Darüber hinaus beeinflussen auch Instabilitäten der Referenzspannung $u_{REF}$ die Messergebnisse.

Bei den in Figur 1 und 2 gezeigten Messschaltungen sind daher die Betriebsspannung Ub und gegebenenfalls die Referenzspannung $u_{REF}$ konstant zu halten, was mit entsprechendem Aufwand verbunden ist. Dieser Nachteil wird in der Messschaltung von Figur 3 vermieden, in der das Verhältnis des Kompensationsstroms $i_K$ und des durch den zweiten Knotenpunkt K2 der Messbrücke gegen Erde GND fliessenden Brückenstroms $i_B$ gebildet und zur Bestimmung der Messgrösse verwendet wird. Dieses Verhältnis $i_K/i_B$ bleibt bei Änderungen der Betriebsspannung Ub konstant, so dass deren Instabilitäten ohne Einfluss auf die Messung bleiben. Für die Messschaltung von Figur 3 ist daher nur eine Spannungsquelle erforderlich, an deren Stabilität wesentlich geringere Anforderungen zu stellen sind.

Die in den Figuren 1, 2 und 3 gezeigten Messschaltungen werden nachstehend im Detail erläutert. Zur besseren Übersicht sind in den Messschaltungen von Figur 2 und Figur 3 die gleichen A/D Wandler ADC eingezeichnet.

Wie bereits erwähnt, können bei erfindungsgemässen Messschaltungen alle Widerstände der Messbrücke zur Messung einer Grösse, beispielsweise der Feuchte, Temperatur oder eines Druckes verwendet werden (siehe Figur 1 und Figur 2).

In der in Figur 3 gezeigten Messschaltung dient nur der Widerstand R1 der Messbrücke als Messwiderstand, beispielsweise als Temperaturfühler. Sofern sich dessen Wert erhöht, wodurch die am Knotenpunkt K3 des ersten Brückenzweigs und somit auch die am Ausgang Operationsverstärkers OA1 anliegende Spannung u1 bzw. $u_{OUT}$ absinkt, wird der P-Kanal Feldeffekttransistor FET1 niederohmiger und reduziert dadurch die am Knotenpunkt K4 des zweiten Brückenzweigs anliegende Spannung u2. Die Grösse des vom Knotenpunkt K4 des zweiten Brückenzweigs gegen Erde GND geführten Kompensationsstroms $i_K$ ist daher vom Wert des Messwiderstandes R1 und somit von dessen Temperatur $\vartheta$ abhängig. Durch Messung des Kompensationsstroms $i_K$ können Temperaturänderungen daher präzise festgestellt werden. Diese Betrachtungen gelten analog für die Messschaltungen von Figur 1 und Figur 2. Der Kompensationsstrom $i_K$ kann dabei wie in der Folge dargelegt berechnet werden.

Bei geregelter Brückenspannung, das heisst mit u1 = u2, gelten die folgenden einfachen Gleichungen, aus welchen sich der Kompensationsstrom $i_K$ durch sukzessive Eliminierung nicht interessierender Variablen berechnen lässt.

$$Ub = i_{R12}*R1 + u1$$

$$Ub = i_{R3}*R3 + u1$$

$$u1 = i_{R12}*R2 + i_B*R6$$

$$u1 = i_{R4}*R4 + i_B*R6$$

$$i_B = i_{R12} + i_{R4}$$

$$i_{R3} = i_K + i_{R4}$$

Nach einigen Rechenschritten über die Zwischenresultate

$$i_{R12} = (Ub - i_B*R6)/(R1 + R2)$$

$$i_{R3} = (Ub - i_B*R6)*R1/(R3*(R1 + R2))$$

$$i_{R4} = (Ub - i_B*R6)*R2/(R4*(R1 + R2))$$

folgt:

$$i_B = Ub*(R2 + R4)/((R1 + R2)*R4 + (R2 + R4)*R6)$$

$$i_K = Ub*(R1*R4 - R2*R3)/(R3*((R1 + R2)*R4 + (R2 + R4)*R6))$$

woraus sich als Verhältnis von $i_K$ zu $i_B$ ergibt:

$$i_K/i_B = (R1*R4 - R2*R3)/(R3*(R2 + R4))$$

Die Gleichungen für $i_B$ und $i_K$ zeigen die lineare Abhängigkeit der beiden Ströme von der Betriebsspannung Ub, wogegen das Verhältnis $i_K/i_B$ nur von den Widerstandswerten der Brücke abhängt, also weder von der Betriebsspannung Ub noch dem Referenzwiderstand R6. Unter der für die Figur 3 getroffenen Annahme mit R1 als Messwiderstand, wird der Brückenstrom $i_B$ von den Änderungen des Werts des Messwiderstands nur unwesentlich beeinflusst, sofern R6 gross ist im Vergleich zu R1 und R4. Unter dieser Voraussetzung ist auch $i_K$ in grober Näherung proportional zu R1. Für die Schaltungen der Figuren 1 und 2, für welche die Gleichungen mit R6 = 0 ja ebenfalls gelten, ist die genannte Voraussetzung nicht erfüllbar. Da aber Messwiderstände als Sensoren für die Temperatur-, Druck-, Feuchte- oder sonstige Messwertbestimmung im allgemeinen keinen linearen Verlauf aufweisen, ist eine entsprechende Skalierung der Messwerte ohnehin unumgänglich. Für die Anordnung nach Fig. 1 muss ausserdem die Bedingung R1*R4 > R2*R3 erfüllt sein, da $i_K$ nicht negativ werden kann. Anders bei der Anordnung nach Figur 3, wo $u_{IB}$ als Referenz verwendet und somit $i_X$ als Vergleichsstrom zu $i_K$ am A/D-Wandler nicht als feste Grösse wie in Fig. 2, sondern als Abbild von $i_B$ eingeprägt wird. Der A/D-Wandler liefert daher als Resultat eine zum Verhältnis $i_K/i_B$ proportionale Grösse, welches seinerseits, wie die Gleichung zeigt, unabhängig von Ub und R6 eine zu R1 proportionale Grösse liefert. Überdies lässt sich mit geeigneter Wahl der Werte der Brückenwiderstände der Bereich und die Empfindlichkeit der Messgeraden festlegen.

Die Verwendung der Ströme $i_K$, $i_B$ für die Messung erlaubt ferner die Ausschaltung von Fehlern, die bei der Verwendung von Spannungen auftreten können. Die Ströme $i_K$, $i_B$ können über eine grössere Distanz übertragen werden, ohne dass sich deren Werte ändern oder die Widerstände der Übertragungsleitung eine Rolle spielen.

In Figur 2 und Figur 3 ist daher symbolisch eine Übertragungsleitung LTG dargestellt, mittels welcher der Strom $i_K$ bzw. die Ströme $i_K$, $i_B$ von der Brückenschaltung zum A/D Wandler ADC übertragbar ist bzw. sind.

Ferner ist bei der erfindungsgemässen Messschaltung der Messbereich wählbar. Der Messbereich wird dabei durch entsprechende Dimensionierung der Bauteile der Messschaltung festgelegt, so dass der minimal und der maximal auftretende Wert des Kompensationsstroms die gewünschten Eckwerte des Messbereichs darstellen.

Besonders vorteilhaft erfolgt die Messung der Ströme $i_K$, $i_B$ mit einem A/D Wandler, der nach dem Ladungsausgleichsprinzip bzw. dem Charge-Balancing-Verfahren arbeitet, welches in der in [2] beschriebenen Messschaltung angewendet wird. Das Charge-Balancing-Verfahren, bei dem mit geringem Schaltungsaufwand eine hohe Genauigkeit und Störunterdrückung erzielt werden kann, wird vorzugsweise in Messgeräten angewendet, da dort die relativ lange Umsetzdauer nicht störend in Erscheinung tritt.

Beim Charge-Balancing Verfahren wird ein analoges Eingangssignal während einer ganzen Periode T integriert, wodurch ein integrierender Kondensator eine entsprechende Ladungsänderung erfährt. Zur Kompensation dieser vom Eingangssignal abhängigen Ladungsänderung wird dem Kondensator während eines Anteils t der Periode T wieder eine entsprechende Ladung entnommen. Das Tastverhältnis wird bei konstanter Periodendauer T daher derart geregelt, dass sich die innerhalb der Periodenanteile t und T-t auftretenden Ladungsverschiebungen vollständig kompensieren. Der resultierende Periodenanteil t, dessen Dauer mittels eines Zählers gemessen wird, ist sodann ein Mass für die Messgrösse.

Das oben beschriebene Prinzip kommt in der in Figur 2 gezeigten vorzugsweisen Ausgestaltung der erfindungsgemässen Messschaltung wie folgt zur Anwendung.

Der P-Kanal Feldeffekttransistor FET1 verbindet den Knotenpunkt K4 des zweiten Brückenzweigs über einen Widerstand R5 sowie einen als Schalter dienenden N-Kanal Feldeffekttransistor FET2 mit Erde GND.

Zur Messung des Kompensationsstroms $i_K$ ist der Knotenpunkt K5 mit dem invertierenden Eingang eines zweiten Operationsverstärkers OA2 verbunden, der mittels eines den invertierenden Eingang mit dem Ausgang verbindenden Kondensators C1 als Integrator beschaltet ist. Der N-Kanal Feldeffekttransistor FET2 wird nun periodisch mit einer Frequenz 1/T derart umgeschaltet, dass er für einen ersten Anteil t der Periodendauer T leitet und für den zweiten Anteil T-t der Periodendauer T sperrt. Über den Knotenpunkt K5 erfolgt innerhalb einer Periode T daher ein Austausch von Ladungen, die sich bei eingeregeltem Tastverhältnis vollständig kompensieren.

Während der gesamten Periode T fliesst somit der Kompensationsstrom $i_K$ über den P-Kanal Feldeffekttransistor FET1 in den A/D Wandler ADC. Während des ersten Periodenanteils t, während dessen der N-Kanal Feldeffekttransistor FET2 leitet, fliesst ein Strom $i_X$ aus dem Knotenpunkt K5 gegen Erde GND. Während des zweiten Periodenanteils T-t, während dessen der N-Kanal Feldeffekttransistor FET2 sperrt, fliesst hingegen nur der Kompensationsstrom $i_K$ über den Knotenpunkt K5 in den Kondensator C1.

Dem Kondensator C1 wird daher im ersten Periodenanteil t die Ladung t * ($i_X$ - $i_K$) entnommen und im zweiten Periodenanteil T-t die Ladung (T-t) * $i_K$ zugeführt, welche beiden Ladungen bei eingeregeltem Tastverhältnis gleich gross sind. Die Dauer des ersten Periodenanteils t ist daher ein Mass für die Grösse des Kompensationsstroms $i_K$. Voraussetzung für das Funktionieren ist $i_X > i_K$.

Der Ausgang des zweiten Operationsverstärkers OA2, an dem die Spannung $u_C$ anliegt, ist mit dem invertierenden Eingang eines Komparators CMP verbunden, dessen nicht-invertierender Eingang am Ausgang eines Rampengenerators RG anliegt, dessen rampenförmig abfallendes Ausgangssignal $u_R$ innerhalb der Arbeitsperioden T, die mittels einer nur jeden n-ten Taktimpuls weitergebenden Frequenz-Teilungsstufe DIV aus Taktimpulsen $T_{CK}$ eines Taktgenerators abgeleitet sind, periodisch zurückgesetzt wird. Voraussetzung ist, dass die Rampenabfallgeschwindigkeit $du_R/dt$ grösser ist als die maximale Abfallgeschwindigkeit von $u_C$, wofür der Referenzstrom $i_X$ und der Kondensator C1 die Grenzen liefern; Verhältnisoptimierungen sind dem Fachmann wohl bekannt.

Der Ausgang des Komparators CMP ist mit dem Signaleingang D einer Kippstufe FF, beispielsweise eines D-Flip Flop's verbunden, dessen Takteingang CK mit Taktimpulsen $T_{CK}$ beaufschlagt ist und dessen nicht-invertierender Ausgang Q den als Schalter dienenden N-Kanal Feldeffekttransistor FET2 steuert. Der nicht-invertierende Ausgang Q der Kippstufe FF ist ferner mit dem ersten Eingang eines UND-Tors AG verbunden, dessen zweiter Eingang mit Taktimpulsen $T_{CK}$ beaufschlagt ist und dessen Ausgang mit dem Takteingang CK eines Zählers CTR verbunden ist, dem innerhalb des ersten Periodenanteils t daher jeweils Taktimpulse $T_{CK}$ zugeführt werden. Der Ausgang des Zählers CTR, dessen Reset-Eingang mit dem Ausgang der Teilungsstufe DIV verbunden ist und der daher nach jeder Arbeitsperiode T zurückgesetzt wird, ist mit einer Anzeigeeinheit DP verbunden, die den während des ersten Periodenanteils t erreichten Zählerstand anzeigt, der ein Mass für die Grösse des Kompensationsstroms $i_K$ und somit der Messgrösse, beispielsweise der Temperatur $\vartheta$, ist.

Sofern die Temperaturmessung in einem Messgerät, beispielsweise in der in [1] beschriebenen Kraftmessvorrichtung, zur Korrektur von temperaturabhängigen Messabweichungen dient, wird der Zählerstand hingegen einer Korrekturschaltung zugeführt, die einen dazu korrespondierenden Korrekturwert aus einem Speicher abruft und damit den ermittelten Messwert korrigiert.

Mit Bezug auf die Bestimmung der Messgrösse wurde oben beschrieben, dass die Temperatur $\vartheta$ vorteilhaft durch Messung des Stromverhältnisses $i_K/i_B$ bestimmt werden kann, wodurch gleichzeitig Schwankungen der Betriebsspannung Ub berücksichtigt werden.

In der in Figur 3 gezeigten vorzugsweisen Ausgestaltung der Messschaltung ist daher der nicht-invertierende Eingang des zweiten Operationsverstärkers OA2, nicht wie bei bekannten Schaltungen üblich, mit einem von der Betriebsspannung Ub unabhängigen Referenzpotenzial $u_{REF}$ (siehe Figur 2), sondern mit einer zum Brückenstrom $i_B$ proportionalen Spannung $u_{IB}$ verbunden, die am Knotenpunkt K6 über einem vom Brückenstrom $i_B$ durchflossenen Widerstand R6 gebildet wird. Schwankungen der Betriebsspannung Ub, die den Brückenstrom $i_B$ und den Kompensationsstrom $i_K$ gleichermassen beeinflussen, werden daher im gewandelten Ausgangssignal kompensiert.

Die erfindungsgemässe Messschaltung wurde in einer bevorzugten Ausgestaltung beschrieben und dargestellt. Anhand der erfindungsgemässen Lehre sind jedoch weitere fachmännische Ausgestaltungen realisierbar. Insbesondere sind verschiedene Schaltungen einsetzbar, mittels derer der Kompensationsstrom $i_K$, gegebenenfalls bezogen auf den Brückenstrom $i_B$, messbar ist. Beispielsweise kann die Polarität der Schaltung umgekehrt und der Kompensationsstrom über einen regelbaren Widerstand in Form eines N-Kanal Feldeffekttransistors zugeführt werden. Der Fachmann wird keine Schwierigkeiten haben, die Schaltungen entsprechend auszulegen. Aufgrund des einfachen Aufbaus der Messschaltung, kann diese den vorliegenden Bedürfnissen durch entsprechende Dimensionierung der Bauteile leicht angepasst werden. Insbesondere ist ein Messbereich mit gewünschter Unter- und Obergrenze leicht realisierbar. Selbstverständlich kann die Messschaltung auch mit weiteren Bauteilen ergänzt werden, die beispielsweise der Unterdrückung von Störsignalen dienen.

Die erfindungsgemässe Messschaltung kann ferner zur Messung beliebiger Messgrössen (siehe [3], Seiten 1222-1223, Tabelle 23.1) verwendet werden, welche das Verhalten einer Messbrücke in der oben beschriebenen Weise beeinflussen.

Literaturverzeichnis

[1] EP 0 990 880 A2
[2] EP 0 173 833 A2
[3] U. Tietze, Ch. Schenk, Halbleiterschaltungstechnik, 11. Auflage, 1. Nachdruck, Springer Verlag, Berlin 1999
[4] US 4 063 447 A
[5] Operač ní zesilovač e v elektronice", 2002, Technická Literatura BEN, Praha, Seiten 267 bis 268
[6] US 4 456 390 A

**Patentansprüche**

1. Messschaltung mit einer Brückenschaltung bestehend aus zwei parallelen Brückenzweigen, die über einen ersten Knotenpunkt (K1) an eine Betriebsspannung (Ub) und über einen zweiten Knotenpunkt (K2), gegebenenfalls mittelbar, am Bezugspotenzial Erde (GND) angeschlossen sind und von denen jeder zwei zu einem dritten beziehungsweise vierten Knotenpunkt (K3; K4) zusammengeschaltete Widerstände (R1, R2; R3, R4)enthält, von denen wenigstens einer seinen Wert in Abhängigkeit einer zu messenden Grösse ändert, **dadurch gekennzeichnet, dass** die Messschaltung derart ausgelegt ist, dass im Messbetrieb dem vierten Knotenpunkt (K4) ständig ein über einen steuerbaren Widerstand (FET1) beeinflusster Kompensationsstrom ($i_K$) entnommen wird, wobei der steuereingang des steuerbaren Widerstands (FET1) mit dem Ausgang eines mit seinen Eingängen am dritten Knotenpunkt (K3) beziehungsweise vierten Knotenpunkt (K4) angeschlossenen Operationsverstärkers (OA1) verbunden ist, und der Kompensationsstrom ($i_K$) derart regelbar ist, dass die Differenz zwischen einer am dritten Knotenpunkt (K3) auftretenden Spannung (u1) und einer am vierten Knotenpunkt (K4) auftretenden Spannung (u2) stets Null bleibt, auch wenn der wenigstens eine Widerstand (R1, R2; R3, R4) seinen Wert in Abhängigkeit von der zu messenden Grösse ändert, so dass der Kompensationsstrom ($i_K$) ein Mass für die messende Grösse darstellt.

2. Messschaltung nach Anspruch 1, **dadurch gekennzeichnet, dass** der steuerbare Widerstand (FET1) zwischen den vierten Knotenpunkt (K4) und das Bezugspotenzial Erde (GND) in den Pfad des Kompensationsstroms ($i_K$) geschaltet ist und den Kompensationsstrom ($i_K$) führt.

3. Messschaltung nach Anspruch 1 oder 2, **dadurch gekennzeichnet, dass** der Kompensationsstrom ($i_K$) oder ein durch das Verhältnis des Kompensationsstroms ($i_K$) zum durch den zweiten Knotenpunkt (K2) gegen das Bezugspotenzial Erde (GND) fliessenden Brückenstrom ($i_B$)bestimmter, normierter Kompensationsstrom gemessen und zur Bestimmung der Messgrösse verwendet wird.

4. Messschaltung nach Anspruch 1, 2 oder 3, **dadurch gekennzeichnet, dass** der Kompensationsstrom ($i_K$) oder gegebenenfalls der anhand des Brückenstroms ($i_B$) normierte Kompensationsstrom mittels eines, insbesondere nach dem Ladungsausgleichsprinzip arbeitenden, A/D Wandlers (ADC) gemessen wird.

5. Messschaltung nach Anspruch 4, **dadurch gekennzeichnet, dass** ein erster Referenzwiderstand (R5) zwischen den steuerbaren Widerstand (FET1) und das Bezugspotenzial Erde (GND) geschaltet ist und, falls ein normierter Kompensationsstrom gemessen wird, ein zweiter Referenzwiderstand (R6) zwischen dem zweiten Knotenpunkt (K2) und dem Bezugspotenzial Erde (GND) in den Pfad des Brückenstroms ($i_B$) geschaltet ist, wobei am ersten Referenzwiderstand (R5) eine dem durch ihn fliessenden strom Korrespondierende erste Spannung ($u_{IK}$) auftritt und am gegebenenfalls vorhandenen zweiten Referenzwiderstand (R6) eine dem Brückenstrom ($i_B$) korrespondierende zweite Spannung ($u_{IB}$) auftritt, welche Spannung ($u_{IK}$)/Spannungen ($u_{IK},u_{IB}$) dem A/D Wandler (ADC) zugeführt wird/werden.

6. Messschaltung nach Anspruch 5, **dadurch gekennzeichnet, dass** der Kompensationsstrom ($i_K$) und gegebenenfalls der Brückenstrom ($i_B$) dem jeweils Zugehörigen Referenzwiderstand ($R_5$, $R_6$) über eine Übertragungsleitung (LTG) zuführbar ist.

7. Messschaltung nach Anspruch 5 oder 6, **dadurch gekennzeichnet, dass** der erste Referenzwiderstand (R5) mit seinem dem Bezugspotenzial Erde (GND) abgewandten Anschluss mit einem Eingang eines zweiten, als Integrator beschalteten Operationsverstarkers (OA2) verbunden ist, an dessen anderem Eingang eine Referenzspannung ($u_{Ref}$) beziehungsweise die bei Vorhandensein eines Zweiten Referenzwiderstands (R6) an diesem auftretende zweite Spannung ($u_{IB}$) anliegt, und dass zwischen dem Referenzwiderstand (R5) und dem Bezugspotenzial Erde (GND) ein Schalter (FET2) angeordnet ist, der periodisch derart betätigbar ist, dass dem Integrator während Anteilen t und T-t jeder Arbeitsperiode T vom Kompensationsstrom ($i_K$) abhängige Ladungen entnehmbar beziehungsweise wieder zuführbar sind, wobei die Grösse entnehmbarer Ladungen der Grösse zuführbarer Ladungen durch Änderung der jeweiligen Periodenanteile t und T-t angleichbar ist, so dass die Dauer des Periodenanteils t oder T-t ein digital darstellbares Mass für die Grösse des Kompensationsstroms ($i_K$) ist.

8. Messschaltung nach Anspruch 7, **dadurch gekennzeichnet, dass** der zweite Referenzwiderstand (R6) mit seinem dem Bezugspotenzial Erde (GND) abgewandten Anschluss mit dem anderen Eingang des zweiten Operationsverstärkers (OA2) verbunden ist und so die zweite Spannung als die Referenzspannung ($u_{iB}$) festlegt, so dass die Dauer des Periodenanteils t oder T-t ein digital darstellbares Mass für die Grösse des mittels des Brückenstrom ($i_B$) normierten Kompensationsstroms ist.

9. Messschaltung nach Anspruch 8, **dadurch gekennzeichnet, dass** der Ausgang des zweiten Operationsverstärkers (OA2) mit dem invertierenden Eingang eines Komparators (CMP) verbunden ist, dessen nicht-invertierendem Eingang eine eine Periodendauer T aufweisende Ausgangsspannung ($u_R$) eines Rampengenerators (RG) zuführbar ist und dessen Ausgang mit dem Signaleingang einer Kippstufe (FF) verbunden ist, deren Ausgangssignale der Steuerung des Schalters (FET2) dienen.

10. Messschaltung nach Anspruch 9, **dadurch gekennzeichnet, dass** der Ausgang der Kippstufe (FF) ausserdem mit einem Zähler (CTR) verbunden ist.

11. Messschaltung nach einem der Ansprüche 1 bis 10, **dadurch gekennzeichnet, dass** die zu messende Grösse zur Gruppe bestehend aus Temperatur, Feuchtigkeit und Druck gehört.

12. Messvorrichtung mit einer Messschaltung nach einem der Ansprüche 1-11, **dadurch gekennzeichnet, dass** die zu messende Grösse eine Temperatur ($\vartheta$) ist und ein in der Messvorrichtung ermittelter, temperaturabhängiger Messwert mittels eines Korrekturwerts korrigierbar ist, der zu einem von der Messschaltung ermittelten Wert der Temperatur ($\vartheta$) korrespondiert.

**Claims**

1. A measuring arrangement with a bridge circuit consisting of two parallel bridge arms that are connected to a operating voltage (Ub) via a first nodal point (K1) and to the reference potential ground (GND) via a second nodal point (K2), if applicable, in an indirect fashion, wherein each branch arm contains two resistors (R1, R2; R3, R4) that are interconnected into a third and a fourth nodal point (K3; K4) and at least one of the resistors (R1, R2, R3, R4) changes its value in dependence on a quantity to be measured, **characterized in that** the measuring arrangement is designed in such a way that a compensation current ($i_K$) that can be influenced by a variable resistor (FET1) is continuously drawn from the fourth nodal point (K4) in the measuring mode, wherein the control input of the variable resistor (FET1) is connected to the output of an operational amplifier (OA1), the inputs of the operational amplifier (OA1) are connected to the third nodal point (K3) and the fourth nodal point (K4) and **in that** the compensation current ($i_K$) can be controlled in such a way that the difference between a voltage (u1) at the third nodal point (K3) and a voltage (u2) at the fourth nodal point (K4) always remains zero, namely even if the at least one resistor (R1, R2; R3, R4) changes its value in dependence on the quantity to be measured, and the compensation current ($i_K$) represents a measure for the quantity to be determined.

2. The measuring arrangement according to Claim 1, **characterized in that** the variable resistor (FET1) is wired into the path of the compensation current ($i_K$) between the fourth nodal point (K4) and the reference potential ground (GND) and carries the compensation current ($i_K$).

3. The measuring arrangement according to Claim 1 or 2, **characterized in that** the compensation current ($i_K$) or a standardized compensation current that is defined by the ratio between the compensation current ($i_K$) and the bridge current ($i_B$) flowing to the reference potential ground (GND) through the second nodal point (K2), is measured and used for determining the quantity to be measured.

4. The measuring arrangement according to Claim 1, 2 or 3, **characterized in that** the compensation current ($i_K$) or, if applicable, the compensation current standardized with the aid of the bridge current ($i_B$) is measured by means of an A/D converter (ADC) that operates, in particular, according to the charge balancing principle.

5. The measuring arrangement according to Claim 4, **characterized in that** a first reference resistor (R5) is arranged between the variable resistor (FET1) and the reference potential ground (GND), and if a standardized compensation current is measured that a second reference resistor (R6) is arranged in the path of the bridge current ($i_B$) between the second nodal point (K2) and the reference potential ground (GND), wherein a voltage ($u_{IK}$) that corresponds to the current flowing through the first reference resistor (R5) occurs at this first reference resistor (R5) and a second voltage ($u_{IB}$) that corresponds to the bridge current ($i_B$) occurs, if applicable, at the second reference resistor (R6), and wherein said voltage ($i_{IK}$) / voltages ($u_{IK}$, $u_{IB}$) is/are fed to the A/D converter (ADC).

6. The measuring arrangement according to Claim 5, **characterized in that** the compensation current ($i_K$) and, if applicable, the bridge current ($i_B$) can be fed to the respectively assigned reference resistors (R5, R6) via a transmission line (LTG).

7. The measuring arrangement according to Claim 5 or 6, **characterized in that** the first reference resistor (R5) is connected with its opposite connection referred to the reference potential ground (GND) to an input of a second operational amplifier (OA2) wired in the form of an integrator, wherein a reference voltage ($u_{REF}$) or, if a second reference resistor (R6) is provided, the second voltage ($u_{IB}$) occurring at the second reference resistor is fed to the other input of the operational amplifier, and **in that** a switch (FET2) is arranged between the reference resistor (R5) and the reference potential ground (GND), wherein said switch is periodically actuated in such a way that charges dependent on the compensation current ($i_K$) can be drawn from and supplied to the integrator during segments t and T-t of each working period T, wherein the intensity of drawn charges can be matched with the intensity of supplied charges by changing the respective period segments t and T-t such that the duration of the period segment t or T-t represents a measure for the quantity of the compensation current ($i_K$) that can be digitally displayed.

8. The measuring arrangement according to Claim 7, **characterized in that** the second reference resistor (R6) is connected to the other input of the second operational amplifier (OA2) with its opposite connection referred to the reference potential ground (GND) and thusly defines the second voltage as the reference voltage ($u_{IB}$), namely such that the duration of the period segment t or T-t represents a digitally displayable measure for the intensity of the compensation current standardized by means of the bridge current ($i_B$).

9. The measuring arrangement according to Claim 8, **characterized in that** the output of the second operational amplifier (OA2) is connected to the inverting input of a comparator (CMP), wherein an output voltage ($u_R$) of a ramp generator (RG) that has a period T can be fed to the non-inverting input of said comparator, and wherein the output of the comparator is connected to the signal input of a flip-flop (FF), the output signals of which serve for controlling the switch (FET2).

10. The measuring arrangement according to Claim 9, **characterized in that** the output of the flip-flop (FF) is also connected to a counter (CTR).

**11.** The measuring arrangement according to one of Claims 1-10, **characterized in that** the quantity to be measured belongs to a group consisting of temperature, humidity and pressure.

**12.** A measuring device with a measuring arrangement according to one of Claims 1-11, **characterized in that** the quantity to be measured is a temperature ($\vartheta$) and a temperature-dependent value determined in the measuring arrangement can be corrected by means of a correction value that corresponds to a value of the temperature ($\vartheta$) determined by the measuring arrangement.


**Revendications**

**1.** Circuit de mesure avec un circuit en pont comprenant deux branches de pont parallèles, qui sont raccordées par un premier point nodal (K1) à une tension de service (Ub) et par un second point nodal (K2), éventuellement indirectement, au potentiel de référence de terre (GND) et dont chacune contient deux résistances (R1, R2 ; R3, R4) interconnectées pour former un troisième ou quatrième point nodal (K3 ; K4), résistances (R1, R2, R3, R4) dont au moins une modifie sa valeur en fonction d'une grandeur à mesurer, **caractérisé en ce que** le circuit de mesure est conçu de telle sorte que, pendant la mesure, un courant de compensation ($i_K$) influencé par une résistance (FET1) contrôlable est prélevé constamment sur le quatrième point nodal (K4), l'entrée de commande de la résistance (FET1) contrôlable étant reliée à la sortie d'un amplificateur opérationnel (OA1) qui est raccordé avec l'une de ses entrées sur le troisième point nodal (K3) et avec l'autre de ses entrées sur le quatrième point nodal (K4), et le courant de compensation ($i_K$) peut être réglé de telle sorte que la différence entre une tension (u1) apparaissant sur le troisième point nodal (K3) et une tension (u2) apparaissant sur le quatrième point nodal (K4) reste toujours nulle, même si la au moins une résistance (R1, R2 ; R3, R4) modifie sa valeur en fonction de la grandeur à mesurer, de sorte que le courant de compensation ($i_K$) représente une référence pour la grandeur à mesurer.

**2.** Circuit de mesure selon la revendication 1, **caractérisé en ce que** la résistance (FET1) contrôlable est branchée entre le quatrième point nodal (K4) et le potentiel de référence terre (GND) dans le chemin du courant de compensation ($i_K$) et guide le courant de compensation ($i_K$).

**3.** Circuit de mesure selon la revendication 1 ou 2, **caractérisé en ce que** le courant de compensation ($i_K$) ou un courant de compensation normalisé, déterminé par le rapport entre le courant de compensation ($i_K$) et le courant de pont ($i_B$) circulant à travers le deuxième point nodal (K2) vers le potentiel de référence terre (GND), est mesuré et est utilisé pour la détermination de la grandeur de mesure.

**4.** Circuit de mesure selon la revendication 1, 2 ou 3, **caractérisé en ce que** le courant de compensation ($i_K$) ou éventuellement le courant de compensation normalisé à l'aide du courant du pont ($i_B$) est mesuré au moyen d'un convertisseur analogique/numérique (ADC) travaillant en particulier selon le principe de compensation de charge.

**5.** Circuit de mesure selon la revendication 4, **caractérisé en ce qu'**une première résistance de référence (R5) est branchée entre la résistance (FET1) contrôlable et le potentiel de référence terre (GND) et, si un courant de compensation normalisé est mesuré, une seconde résistance de référence (R6) est branchée entre le deuxième point nodal (K2) et le potentiel de référence terre (GND) dans le chemin du courant de pont ($i_B$), une première tension ($u_{IK}$) correspondant au courant circulant à travers la première résistance de référence (R5) apparaissant sur cette résistance et une seconde tension ($u_{IB}$) correspondant au courant de pont ($i_B$) apparaissant sur la seconde résistance de référence (R6) éventuellement présente, laquelle tension ($u_{IK}$)/lesquelles tensions ($u_{IK}$, $u_{IB}$) étant amenée/amenées au convertisseur analogique/numérique ADC.

**6.** Circuit de mesure selon la revendication 5, **caractérisé en ce que** le courant de compensation ($i_K$) et éventuellement le courant de pont ($i_B$) peuvent être amenés à la résistance de référence (R5, R6) correspondante respective au moyen d'une ligne de transmission (LTG).

**7.** Circuit de mesure selon la revendication 5 ou 6, **caractérisé en ce que** la première résistance de référence (R5) est reliée avec son raccordement opposé au potentiel de référence terre (GND) à une entrée d'un second amplificateur opérationnel (OA2) équipé comme intégrateur, sur l'autre entrée duquel une tension de référence ($u_{Ref}$) ou la seconde tension ($u_{IB}$) apparaissant en cas de présence d'une seconde résistance de référence (R6) sur celle-ci est appliquée, et **en ce qu'**entre la résistance de référence (R5) et le potentiel de référence terre (GND) est disposé un interrupteur (FET2), qui peut être actionné périodiquement de telle sorte que des charges dépendantes du courant de compensation ($i_K$) peuvent être prélevées ou amenées de nouveau sur l'intégrateur pendant des parties t et T-t de chaque période de travail T, la grandeur de charges prélevables pouvant être adaptée à la grandeur de charges pouvant être amenées par variation des parties de période respectives t et T-t, de sorte que la durée de la partie de période t ou T-t est une référence pouvant être présentée de façon numérique pour la grandeur du courant de compensation ($i_K$).

**8.** Circuit de mesure selon la revendication 7, **caractérisé en ce que** la seconde résistance de référence (R6) est reliée par son branchement, opposé au potentiel de référence terre (GND), à l'autre entrée du second amplificateur opérationnel (OA2) et définit ainsi la seconde tension comme la tension de référence ($u_{IB}$), de sorte que la durée de la partie de période t ou T-t est une référence pouvant être présentée de façon numérique pour la grandeur du courant de compensation normalisé au moyen du courant de pont ($i_B$).

**9.** Circuit de mesure selon la revendication 8, **caractérisé en ce que** la sortie du second amplificateur opérationnel (OA2) est reliée à l'entrée inversante d'un comparateur (CMP), à l'entrée non inversante duquel une tension de sortie ($u_R$), présentant une durée de période T, d'un générateur de rampe (RG) peut être amenée et dont la sortie est reliée à l'entrée de signal d'un niveau de basculement (FF), dont les signaux de sortie servent à la commande de l'interrupteur (FET2).

**10.** Circuit de mesure selon la revendication 9, **caractérisé en ce que** la sortie du niveau de basculement (FF) est reliée d'autre part à un compteur (CTR).

**11.** Circuit de mesure selon l'une quelconque des revendications 1 à 10, **caractérisé en ce que** la grandeur à mesurer fait partie du groupe comprenant la température, l'humidité et la pression.

**12.** Circuit de mesure avec un circuit de mesure selon l'une quelconque des revendications 1 à 11, **caractérisé en ce que** la grandeur à mesurer est une température ($\vartheta$) et une valeur de mesure déterminée dans le dispositif de mesure et dépendante de la température peut être corrigée au moyen d'une valeur de correction, laquelle correspond à une valeur, déterminée par le circuit de mesure, de la température ($\vartheta$).

**FIGUR 1**

FIGUR 2

**FIGUR 3**